# EUROPEAN PATENT SPECIFICATION

(11) **EP 1 601 030 B1**
(45) Date of publication and mention of the grant of the patent: **03.04.2019**
(21) Application number: 05009509.0
(22) Date of filing: 29.04.2005
(51) Int. Cl.: H01L 51/50, G02F 1/23, H01L 33/44

(54) **Light-emitting electronic component**
Elektronisches elektrolumineszentes Bauteil
Composant électronique électroluminescent

(30) Priority: 24.05.2004 US 853570; 16.08.2004 EP 04019412
(43) Date of publication of application: 30.11.2005
(73) Proprietor: OSRAM OLED GmbH, 93049 Regensburg (DE)
(72) Inventor: Diekmann, Karsten, 94371 Rattenberg (DE); Heuser, Karsten, 91056 Erlangen (DE)
(74) Representative: Epping - Hermann - Fischer

(56) References cited:
- EP-A1- 0 653 902
- WO-A1-01/50187
- US-A- 5 796 509
- US-B1- 6 252 638

## Description

### BACKGROUND OF THE INVENTION

Nowadays light-emitting electronic components, in particular opto-electronic components, are often fabricated in order to emit light of a color in accordance with specific customer requests (Color On Demand).

For this purpose use is often made of a light-emitting electronic component having a comparatively broad spectral distribution, e.g. an appropriate white light source. By means of color filters the color of the light emitted by the component is tailored according to customer's requests. This "custom tailored" color of the light-emitting component is completely determined by the spectral distribution of the light emitted by the component in combination with the absorption properties of the color filter. Since the absorption properties of such filters are usually fixed, e.g. by the dyes used, a customer will find difficulties in varying the color of the light emitted by the electronic component in a simple manner without considerable effort.

Document WO 01/50187 A1 relates to a tuneable wavelength-selective filter having a variable wavelength transmittance, wherein the filter comprises a twisted nematic liquid crystal cell (TN LCD), a birefringent plate, polarisers and a quarter wave plate. The color-tuning is essentially based on the features that rotation of polarisation orientation of light can be achieved by tuning a driving voltage applied to the TN LCD and that the birefringent plate allows a transformation of polarisation to be converted to a change in color.

Document EP 0653902 A1 relates to a resonance type variable wavelength luminescent device which comprises at least an active layer emitting light and a variable optical length layer, wherein both layers are disposed between two light reflective layers causing resonance of light within the luminescent device. An output spectrum of the emitted light is controlled by tuning the optical length of the optical length layer in response to an input signal. In particular, the optical length is tuned by varying the thickness of the optical length layer. The output spectrum of the emitted light depends on a sum of the optical lengths of all layers including the active layer disposed between the two light reflective layers.

Document US 6,252,638 B1 relates to a color filter device including polarization analysers and an electrically controllable modulator as well as an output retarder for selectively controlling the spectrum of light output by the device. The color filtering is essentially based on the features that the modulator rotates the polarization orientation of light depending upon the voltage applied to the modulator and the polarization analyser allows to let through a certain portion of light in the spectrum with the dedicated polarization orientation.

### SUMMARY OF THE INVENTION

It is therefore an object of the invention to provide a light-emitting electronic component with the spectral distribution of the light emitted by the component, in particular, the color of the emitted light, being tunable in a simple manner during operation of the component.

This object is achieved by means of a light-emitting component according to claim 1. Advantageous refinements of the invention are subject matter of the dependent claims.

A light-emitting electronic component according to the invention comprises:
- at least one light-emitting element intended for the emission of light with a predetermined spectral distribution,
- at least one filter element arranged in the beam path of the light with the predetermined spectral distribution, the transmission properties of said filter element with respect to the light with the predetermined spectral distribution determining the spectral distribution of the light emitted by the light-emitting component,
with the transmission properties of the filter element being tunable during operation of the light-emitting electronic component.

Tuning or varying the transmission properties of the filter element advantageously results in the possibility to vary the spectral distribution of the light emitted by the light-emitting component during operation of the component. The tuning of the transmission properties of the filter element is preferably reversible.

In this way, the color of the light emitted by the electronic component is, preferably continuously, tunable or variable by means of varying the transmission properties of the filter element. Different colors or color nuances can be realized with a single light-emitting electronic component in this way.

In the invention the term "color" may refer to pure or mixed colors and in particular also to white. Pure colored light has color coordinates x and y in the CIE-chromaticity diagram indicating points on the boundary line of this diagram and mixed colored light has color coordinates in the interior of the region bounded by said boundary line.

The predetermined spectral distribution preferably has a comparatively broad band width or broad spectral distribution, particularly preferably in the visible spectral range, resulting in the opportunity to realize different colors of the light emitted by the component utilizing light of a single predetermined spectral distribution in combination with different filter elements having different transmission and/or tuning properties.

It is furthermore preferred that the predetermined spectral distribution essentially has a continuous shape.

It is particularly preferred for the predetermined spectral distribution to have bands in the red, green and/or blue spectral region. Superimposition of such bands may result in a predetermined spectral distribution, being preferably continuous and/or having a suitable high broadness. For example, the predetermined spectral distribution may appear white or white with a small color cast.

In an embodiment of the present invention the light-emitting element comprises at least one opto-electronic element, which emits light due to electroluminescence in at least one functional material or functional layer. The opto-electronic element may, for example, be formed according to a LED structure (Light Emitting Diode) or OLED structure (Organic Light Emitting Device, in particular Organic Light Emitting Diode), the OLED-structure preferably containing at least one organic light emitting material.

A filter element in accordance with the invention may also be utilized for tuning or varying the peak and/or dominant wavelength of a light-emitting element, in particular a light-emitting element having a comparatively narrow predetermined spectral distribution, as for example single chip LED elements, which often show a single band emission spectrum having a spectral width in the order of nanometers, for example 20 nm to 60 nm.

According to the invention the transmission properties of the filter element are tuned electrically. The filter element may be a voltage driven or current driven element, for example with different currents, current densities or voltages applied to the filter element resulting in, preferably distinct, changes of the transmission properties of the filter element. The color of a display illuminated by means of a light-emitting electronic component according to the invention may be tuned or varied externally via external terminals electrically connected to the filter element.

In particular, the color of a monochrome display or an area color display, e.g. an area color self-emitting OLED display, or a LCD may be tuned or varied by tuning the transmission properties of the filter element. An area color self-emitting display is usually understood as a display showing different colors in different areas of the display, with the colors of the different areas being usually fixed and/or determined by the color of light emitted, e.g. by OLEDs, in the respective areas of the display.

The filter element according to the invention contains at least one electrochromic material. Electrochromic materials have transmission properties which may depend on the current injected into and/or the voltage applied to the electrochromic material.

The electrochromic material is preferably chosen such as to exhibit comparatively high transmission in the visible spectral region, said transmission being electrically tunable. A local or global maximum in transmission of the electrochromic material may be shifted electrically to higher or lower wavelengths. Shifting a transmission maximum to lower wavelengths may result in an increase in absorption in regions of higher wavelengths, e.g. in the red or orange spectral region. Shifting a transmission maximum to higher wavelengths, correspondingly, may result in an increase in absorption in regions of lower wavelengths, e.g. in the blue spectral region.

The electrochromic material preferably contains at least one inorganic or at least one organic material. An inorganic electrochromic material may, for example, contain a metal-oxide, e.g. a tungsten-oxide. An organic electrochromic material may, for example, contain at least one polythiophene or other polymeric materials. It is particularly preferred for the organic material to contain PEDOT (Polyethylenedioxythiophene).

According to the invention, the light-emitting element and the filter element are integrated in a common structure, namely in a common layer stack. This facilitates the formation of particular small and/or compact light-emitting electronic components.

In an advantageous refinement of the invention the light-emitting element and/or the filter element are arranged in a housing. This housing may comprise or consist of, a LED or OLED package, an encapsulation and/or a sealing means, for example. A sealing means is particularly useful for light-emitting elements comprising organic light-emitting materials because said organic materials are often very sensitive with respect to moisture or oxidizing agents and may be advantageously protected by means of the sealing means. The housing preferably protects the light-emitting element and/or the filter element. It is particularly preferred for the filter element and the light-emitting element to be arranged in a common housing.

In another preferred embodiment of the invention the light-emitting electronic component comprises electrically conducting leads conductively connected to the light-emitting element and/or the filter element. The leads being conductively connected to external terminals, by means of which the electronic, preferably micro-electronic and/or opto-electronic, component may be actuated externally, e.g. after mounting the electronic component on a circuit board and/or integrating the component in an application as for illumination of an LCD-display in an LCD-display-housing or for a roof panel illumination of a car, for example.

The light-emitting element and the filter element may be actuated independently from one another or commonly during operation of the light-emitting component.

For the former purpose the filter element and the light-emitting element are preferably electrically insulated from one another and/or have separate means for electrical contact connection.

For the latter purpose the filter element and the light-emitting element are preferably conductively connected with one another and/or have a common electrode being preferably arranged between the light-emitting element_and the filter element. Said electrode may be integrated together with filter element and light-emitting element in a common layer stack. The common electrode may be utilized for operating filter element and light-emitting element.

Further features, advantages and refinements of the invention are described in conjunction with the description of the exemplary embodiments in accordance with the figures.

### DESCRIPTION OF THE DRAWINGS

Figure 1 shows a schematic sectional view of a comparative exemplary embodiment of a light-emitting electronic component.
Figure 2 shows a schematic sectional view of an exemplary embodiment of a light-emitting electronic component according to the invention.
Figure 3 shows a schematic sectional view of an exemplary embodiment of a light-emitting electronic component according to the invention.
Figure 4 shows a diagram of the wavelength dependance of the transmission of a filter element for two different voltages.
Figure 5 shows the change in colors of the light emitted by the electronic component according to the invention as a result from tuning the transmission properties of the filter element by means of a representation in the CIE-chromaticity diagram.
Figure 6 shows a schematic sectional view of a comparative exemplary embodiment of a light-emitting electronic component.

Corresponding elements and correspondingly acting elements are equipped with corresponding numerals in the figures.

### DESCRIPTION OF THE EMBODIMENTS

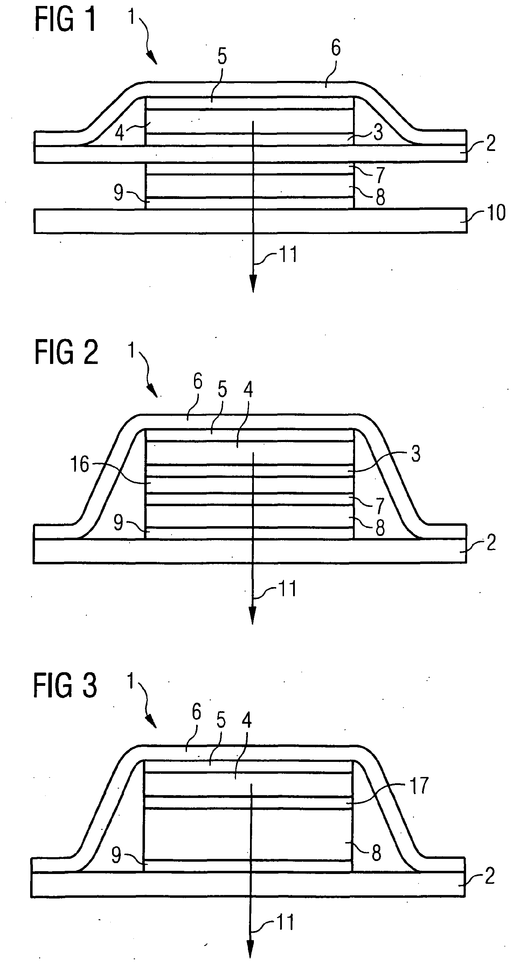

Figure 1 shows a schematic sectional view of a comparative exemplary embodiment of a light-emitting electronic component.

The light-emitting component 1 comprises a window 2, a first electrode 3 arranged on the window followed by an light-emitting layer 4 which is conductively connected to the first electrode 3. A second electrode 5 is arranged on and conductively connected to the light-emitting layer 4 and an encapsulation 6 is provided for increased protection of the light-emitting layer against harmful environmental influences.

A filter element is arranged on the window 2 opposite from the light-emitting element, said filter element comprising a first contact 7 arranged on the window, a filter layer 8 conductively connected to the first contact and a second contact 9 arranged on the filter layer being conductively connected to the filter layer, said second contact in turn being arranged on a carrier 10.

A light-emitting element comprises the light-emitting layer 4 and the electrodes 3, 5, said light-emitting element may for example be formed corresponding to an OLED-structure, and/or the light-emitting layer 4 may comprise or consist of a organic light emitting material. For example, the light-emitting layer may contain an organic polymeric material, e.g. a polyspiro material.

The light-emitting layer may be arranged in a layer stack, said layer stack may comprise at least one additional light-emitting layer and/or other additional layers. In case of an organic light-emitting layer, said layer stack is preferably formed as an organic layer stack, which may additionally comprise a hole transport layer, for example. The hole transport layer may advantageously increase the efficiency of the light-generation in the organic layer stack, especially in the light-emitting layer, by raising the efficiency of hole injection into the light-emitting layer, where electrons and holes may recombine and generate light by means of electroluminescence.

Carrier 10 and window 2 may each or respectively comprise a, preferably essentially transparent and/or electrically insulating material, for example a glass material or a flexible substrate material, e.g. PES (polyethersulfone) or PET (polyethyleneterephtalate). Carrier 10 and window 2 preferably comprise identical materials. The window 2 acts as a window for the light of the predetermined spectral distribution generated in the light-emitting layer and as a carrier which mechanically stabilizes the light-emitting element structure arranged on the window 2.

The carrier 10 preferably acts as a carrier for the filter element comprising contacts 7, 9 and filter layer 8 and due to the light-emitting element structure arranged on the filter element carrier 10 correspondingly acts as a carrier stabilizing the light-emitting component 1. Particularly preferably the carrier 10 also protects the filter element. Additional protection means, e.g. a sealing means or an encapsulation, may also be provided for the filter element, but are not shown in the figures.

The electrodes 3, 5 and/or the contacts 7, 9 may, for example, contain or consist of a transparent material, preferably a TCO-material (Transparent Conducting Oxide), e.g. ITO (Indium Tin Oxide).

The encapsulation 6 may be made of a suitable material, e.g. a suitable sealing material for organic materials known in the field of organic light-emitting devices.

The filter layer 8 preferably contains or consist of at least one inorganic electrochromic material, for example WO₃.

Light of a predetermined spectral distribution generated via electroluminescence in the light-emitting layer 4 is radiated through the electrode 3, the window 2 and first contact 7, filter layer 8, second contact 9 and carrier 10. By applying a voltage to the filter layer 8 resulting in current injection into the filter layer 8 the transmission properties of the filter material are changed. This change in transmission properties results in a change in the spectral distribution of the light 11 emitted by the electronic component 1.
Preferably the light of the predetermined spectral distribution is white light or light of another color having a suitable broad spectral distribution. White light, for example, may be effected by mixing light of different wavelengths emitted by suitable chromophores provided in the organic light emitting material. In case of a polyspiro material emitting in the blue wavelength range, red and green chromophores may be integrated in a copolymer structure, with the mixture of these primary colors (e.g. red, green and blue) resulting in a white light emission of the light-emitting element.

The spectral distribution and/or the color of the light emitted by the electronic component may be influenced by electrically varying or tuning the transmission properties of the filter material.

The intensity of the light emitted by the electronic component may be influenced by appropriate formation of the filter element. In particular the thickness of the filter layer 8 determines the absorption of light and hence the intensity transmitted through the filter element. In this way the filter element may be adapted to the specific needs of various embodiments of the light-emitting electronic component.

The intensity of the light of the predetermined spectral distribution may also be influenced by varying the current density that the light-emitting element is driven with. Decreasing current densities usually correspond to a decrease in intensity of the light generated in the light-emitting layer. In this way the intensity of the light emitted by the electronic component may be varied.

Light-emitting element and filter element may be operated independently by means of the electrodes 3, 5 and the contacts 7, 9 respectively. Contacts 7,9 and electrodes 3,5 may be insulated from each other by means of window 2. Brightness and color coordinates of the light 11 emitted by the electronic component 1 are independently adjustable or tunable. Brightness by means of adjusting the operating current of the light-emitting element via electrodes 3,5 and color coordinates by means of filter element via contacts 7,9.

The light-emitting element may in this exemplary embodiment be formed according to a conventional light-emitting electronic component and the filter element may be provided in an external way, i.e. outside of the light-emitting element structure being arranged inside an encapsulation or on a window of the light-emitting element, for example. This results in comparatively high variability in applications of the light-emitting element, since the filter element may be provided after completion of production of the light-emitting element.

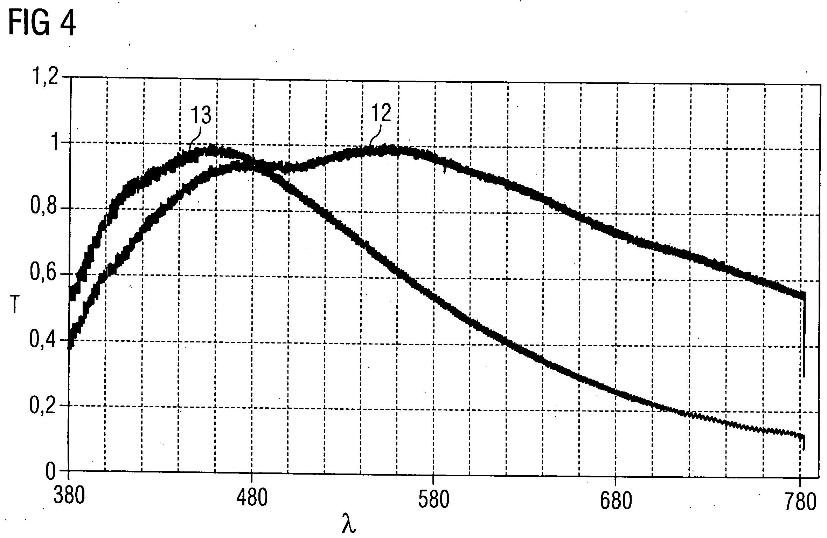

Figure 4 shows quantitatively the dependency of the relative transmission T from the wavelength λ of a WO₃-containing filter element for two different voltages. The relative transmissions are normalized to a value of 1 at corresponding maxima in transmission.

The graph 12 shows the transmission of a WO₃ containing filter element for zero voltage applied to the contacts 7, 9. The transmission according to graph 12 has comparatively high values, of approximately 0.6 or more, in the visible spectral region with particularly high values in the green or yellow region and a maximum at approximately 550 nm.

The graph 13 shows the transmission of a WO₃ containing filter element with 5V applied voltage and current flowing through the filter element. In comparison with graph 12 the transmission is significantly lowered in graph 13 in the visible spectral range, in particular in the orange and red spectral region. The transmission is lowered by 50% or more for wavelengths higher than approximately 600 nm. The transmission maximum in graph 13 lies at approximately 460 nm.

If essentially pure white light having a suitable broad spectral distribution, e.g. white light generated by electroluminescence in an organic polyspiro copolymer Light-emitting -layer with suitable chromophores, is transmitted through the filter element having the transmission properties of graph 12, the amount of light transmitted in the green and yellow spectral region is preferred compared to the outer visible spectral regions blue and red. This results in the transmitted initially essentially pure white light having a white color with a greenish yellowish color cast.

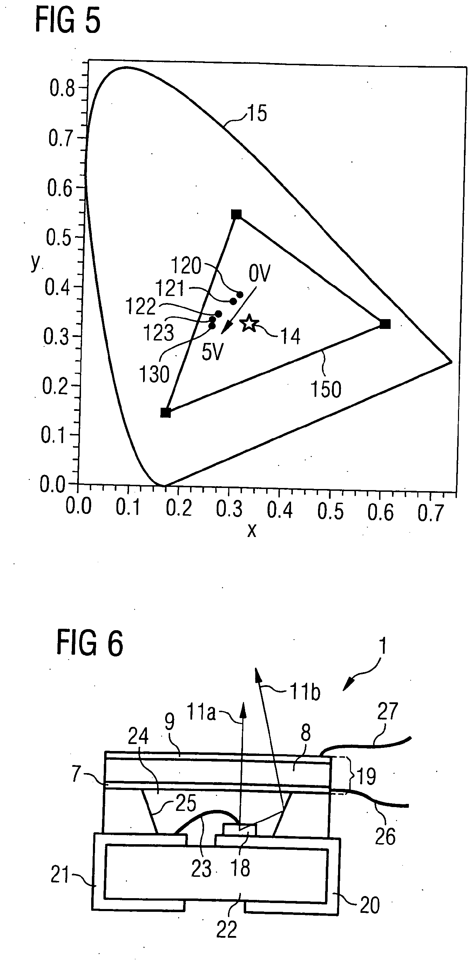

The color of light emitted by an electronic component, e.g. an electronic component as shown in Figure 1, with zero voltage being applied to a WO₃ electrochromic filter layer 8 having the transmission properties as shown in Figure 4, is represented by point 120 in the CIE-chromaticity diagram shown in Figure 5. Point 120 has the coordinates x = 0.31 and y = 0.39 corresponding to a white light having a yellow or green shade of color.

Pure white light is represented by the white point 14 having coordinates x = y = 1/3 in the CIE-chromaticity diagram bounded by the boundary line 15. Colors in the inner area or on the boundary of triangle 150 can be mixed by use of two or three colors having coordinates corresponding to the corners of the triangle.

As the voltage is increased from 0V to 5V, the light emitted by the electronic component changes, as indicated by the arrow, its color coordinates continuously from point 120 over point 121, point 122, point 123 to point 130. Point 130 has the color coordinates x = 0.26 and y = 0.33 and appears as white with a turquoise color cast, due to the absorption being rather high in the red and orange spectral region according to graph 13.

The color coordinates of the light emitted by the electronic component 1 can be varied according to the invention. If an electronic component according to the invention was used as an ambient light source, the color of the ambient light would be tunable. If WO₃, for example, is used as electrochromic filter material, the color of initially white light emitted by the light-emitting layer may be varied, from a rather cool, turquoise shaded, white, to a rather warm, yellow or green shaded, white, and vice versa. A single ambient light-emitting electronic component may thus be used to generate different ambient light caused moods. Cool light, for example is particularly useful as illumination at a place of work and may increase an employee's efficiency at work, whereas warm light is rather related to a spare time mood.

Because the transmission properties of the filter element can be varied electrically and reversibly, the light emitted by the component can be switched and/or continuously tuned between different colors. The intensity of the light emitted by the electronic component may additionally be influenced via the operating current of the light-emitting element, resulting in the light-emitting component being color tunable and dimable.

Figure 2 shows a schematic sectional view of an exemplary embodiment of the present invention which embodiment resembles the embodiment shown in Figure 1. In contrast to the exemplary embodiment of Figure 1, the light-emitting layer 4 and the filter layer 8 are integrated in a common layer stack in the embodiment according to Figure 2. Achieving a small and compact form of the light-emitting component is facilitated herewith.
Filter layer 8 and light-emitting layer 4 may be formed separated from one another and joined after completion of their production. Between light-emitting layer and filter layer an insulating layer 16 is arranged, which insulates electrodes 3, 5 and contacts 7, 9 electrically from one another. The light-emitting element and the filter element may therefore by operated separately.

The insulating layer 16 contains or consists of, for example, a siliconoxide (SiOₓ) or titanium-siliconoxide (TiSiOₓ), with x preferably having values, particularly preferably integer values, satisfying the condition 1 ≤ x ≤ 4.

The layer stack is mechanically stabilized by means of window 2 and protected by the encapsulation 6.

Integration of the filter element and the light-emitting element in a common layer stack facilitates the protection of filter element and light-emitting element with a common protection means, as encapsulation 6 for example.

Figure 3 shows a schematic sectional view of a further exemplary embodiment of the present invention which embodiment resembles the embodiments shown in Figures 1 and 2. In the embodiment of Figure 3 a common electrode 17 is arranged between and conductively connected with filter layer 8 and light-emitting layer 4. The light-emitting element can be operated by means of second electrode 5 and common electrode 17. The transmission properties of the filter element can be varied by applying a voltage to the filter element via common electrode 17 and second contact 9. The difference in the electrical potential between common electrode 17, e.g. the anode of an organic light emitting diode structure, and contact 9 can be tuned by appropriate variation of the electrical potential on contact 9.
The light-emitting component according to this embodiment can be formed with and operated by means of three external terminals, two for the light-emitting element, connected to second electrode 5 and common electrode 17 and one terminal connected to the second contact 9 for electrically tuning the - transmission properties of the filter element. In comparison with the embodiments in Figures 1 and 2, one external electrical terminal, i.e. a terminal connected to the first contact 7 shown in Figures 1 and 2 can be dispensed with.

Figure 6 shows a schematic sectional view of a comparative exemplary embodiment of a light-emitting electronic component by means of a schematic sectional view.

The light-emitting element comprises at least one LED-Chip 18, preferably containing at least one semiconductor material, particularly preferably a III-V-semiconductor material and/or a crystalline semiconductor material, said LED-Chip being arranged in a recess 24 of a housing 22, the housing e.g. containing a plastic material. The LED-Chip is conductively connected to leads 20, 21 via suitable mounting and/or fixing the LED-Chip on lead 20, e.g. by means a conductive adhesive or soldering, and via a bonding wire 23 conductively connected to lead 21. The wall 25 of the recess 24 may be coated fully or partly with a reflection enhancing material, e.g. a metal. The light-emitting element may thus be formed according to a surface mountable device (SMD) being, for example, mountable on a circuit board by means of leads 20 and 21.

Light 11a and 11b generated in the LED-Chip 18 by means of electroluminescence, is emitted by component 1 after transmission through the filter element 19, comprising contacts 7,9 and filter layer 8, containing an electrochromic material, for example. Light 11b is reflected at wall 25 of recess 24 before incidence on the filter element. The transmission properties of the filter layer 8 are electrically tunable via leads 26 and 27 being conductively connected to the filter layer.

The light of the predetermined spectral distribution generated by the light-emitting element is preferably essentially white or mixed colored.

White light may be generated by suitably mixing light emitted by a plurality of LED-Chips, preferably arranged in a common housing and/or emitting in the red, green and blue spectral region, for example. It is particularly preferred for the LED-Chips to have separate leads allowing individual operation of each LED-Chip.

White light may also be generated via luminescence conversion of a part of light of a first wavelength emitted by a single LED-Chip to light of a longer wavelength, by means of an appropriate luminescence conversion material, e.g. a phosphor material, arranged in the recess. The mixture of these two lights may result in white light. For this purpose it is preferred for the LED-Chip to emit in the blue or ultraviolet spectral region and for the light reemitted by the conversion material to be in the yellow or orange spectral region.

The filter element is arranged layer-like on and preferably mechanically fixed to the housing 22 of the light-emitting element. Light-emitting element and filter element may be operated independently by means of terminals connected to the leads 20,21 and 26,27 respectively. The recess may be partly or fully filled with a protection material, e.g. silicone, for increased protection of the LED-Chip. This protection material is preferably formed simultaneously as a carrier material for luminescence conversion particles arranged in or on the material, if luminescence conversion is intended.

The scope of protection of the invention is not limited to the exemplary embodiments described herein above. The invention is embodied in each novel characteristic and each combination of characteristics which particularly includes every combination of any features which are stated in the claims.

In particular a light-emitting electronic component according to the invention may comprise more than one filter element. The light-emitting element may, for example, be arranged between two layer-like filter elements or a plurality of filter elements may be arranged successively in the beam path of the light emitted by the light-emitting element.

Furthermore the filter material does not have to be provided in a layer-like fashion, it may also be provided in another way, e.g. by means of a fluid suitably provided with particles of the filter material with the transmission properties of the filter particles being electrically tunable.

## Claims

1. A light-emitting electronic component (1) comprising:
- at least one light-emitting element having a light-emitting layer (4) conductively connected to and disposed between a first electrode (3) and a second electrode (5) and being intended for the emission of light with a predetermined spectral distribution,
- at least one filter element having a filter layer (8) with an electrochromic filter material conductively connected to and disposed between a first contact (7) and a second contact (9), wherein the light-emitting element and the filter element are integrated in a common layer stack such that the first contact (7), the filter layer (8), the second contact (9), the first electrode (3), the light emitting layer (4) and the second electrode (5) are stacked as a multi-layer structure on a common window (2), wherein
- the at least one filter element is arranged in the beam path of the light with the predetermined spectral distribution; and
- the transmission properties of the filter material of the filter layer (8) are electrically tunable during operation of the light-emitting electronic component (1), such that changes in the transmission properties of the filter material with respect to the light with the predetermined spectral distribution result in a change in the spectral distribution of the light emitted by the light-emitting electronic component.

2. The component (1) according to claim 1, wherein the color of the light emitted by the component (1) is tunable by means of tuning the transmission properties of the filter element.

3. The component (1) according to one of the preceding claims, wherein the light-emitting element comprises at least one opto-electronic element.

4. The component (1) according to one of the preceding claims, wherein the light-emitting element comprises at least one organic light emitting material.

5. The component (1) according to one of the preceding claims, wherein the light-emitting element comprises an organic light emitting diode structure.

6. The component (1) according to one of the preceding claims, wherein the filter material comprises particles provided in a fluid, wherein the transmission properties of the particles are electrically tunable.

7. The component (1) according to claim 1, wherein the electrochromic material contains at least one inorganic material.

8. The component (1) according to claim 7, wherein the inorganic material is a tungsten oxide.

9. The component (1) according to claim 1, wherein the electrochromic material contains at least one organic material.

10. The component (1) according to claim 1, wherein by tuning the transmission properties of the filter material, a local or global maximum in transmission of the electrochromic material is shifted electrically to higher or lower wavelengths, resulting in an increase in absorption in regions of lower wavelengths or higher wavelengths, respectively.

11. The component (1) according to one of the preceding claims, wherein the light-emitting element and the filter element are arranged in a common housing.

12. The component (1) according to one of the preceding claims, wherein the light-emitting element and the filter element can be actuated independently from one another during operation of the light-emitting component.

13. The component (1) according to one of the preceding claims, wherein the light-emitting element and the filter element can be actuated commonly during operation of the light-emitting component (1).

## Patentansprüche

1. Ein lichtemittierendes elektronisches Bauteil (1) umfassend:
- mindestens ein lichtemittierendes Element mit einer lichtemittierenden Schicht (4), die leitend mit einer ersten Elektrode (3) und einer zweiten Elektrode (5) verbunden und zwischen diesen angeordnet ist und für die Emission von Licht mit einer vorgegebenen Spektralverteilung vorgesehen ist,
- mindestens ein Filterelement, das eine Filterschicht (8) mit einem elektrochromen Filtermaterial aufweist, mit einem ersten Kontakt (7) und einem zweiten Kontakt (9) leitend verbunden und zwischen diesen angeordnet ist, wobei das lichtemittierende Element und das Filterelement in einem gemeinsamen Schichtstapel integriert sind, sodass der erste Kontakt (7), die Filterschicht (8), der zweite Kontakt (9), die erste Elektrode (3), die lichtemittierende Schicht (4) und die zweite Elektrode (5) als Mehrschichtstruktur auf einem gemeinsamen Fenster (2) gestapelt sind, wobei
- das mindestens eine Filterelement im Strahlengang des Lichts mit der vorgegebenen spektralen Verteilung angeordnet ist; und
- die Transmissionseigenschaften des Filtermaterials der Filterschicht (8) während des Betriebs des lichtemittierenden elektronischen Bauteils (1) elektrisch abstimmbar sind, sodass Änderungen der Transmissionseigenschaften des Filtermaterials in Bezug auf das Licht mit der vorgegebenen spektralen Verteilung zu einer Änderung der spektralen Verteilung des von dem lichtemittierenden elektronischen Bauteil emittierten Lichts führen.

2. Bauteil (1) nach Anspruch 1,
wobei
die Farbe des von dem Bauteil (1) emittierten Lichts durch Abstimmen der Transmissionseigenschaften des Filterelements abstimmbar ist.

3. Bauteil (1) nach einem der vorhergehenden Ansprüche,
wobei
das lichtemittierende Element mindestens ein optoelektronisches Element umfasst.

4. Bauteil (1) nach einem der vorhergehenden Ansprüche,
wobei
das lichtemittierende Element mindestens ein organisches lichtemittierendes Material umfasst.

5. Bauteil (1) nach einem der vorhergehenden Ansprüche,
wobei
das lichtemittierende Element eine organische lichtemittierende Diodenstruktur umfasst.

6. Bauteil (1) nach einem der vorhergehenden Ansprüche,
wobei
das Filtermaterial Partikel umfasst, die in einem Fluid bereitgestellt sind, wobei die Transmissionseigenschaften der Partikel elektrisch abstimmbar sind.

7. Bauteil (1) nach Anspruch 1,
wobei
das elektrochrome Material mindestens ein anorganisches Material enthält.

8. Bauteil (1) nach Anspruch 7,
wobei
das anorganische Material ein Wolframoxid ist.

9. Bauteil (1) nach Anspruch 1,
wobei
das elektrochrome Material mindestens ein organisches Material enthält.

10. Bauteil (1) nach Anspruch 1,
wobei
ein lokales oder globales Transmissionsmaximum des elektrochromen Materials auf höhere oder niedrigere Wellenlängen durch Abstimmen der Transmissionseigenschaften des Filtermaterials elektrisch verschoben wird, wodurch eine Erhöhung der Absorption in Bereichen mit niedrigeren beziehungsweise höheren Wellenlängen zur Folge hat.

11. Bauteil (1) nach einem der vorhergehenden Ansprüche,
wobei
das lichtemittierende Element und das Filterelement in einem gemeinsamen Gehäuse angeordnet sind.

12. Bauteil (1) nach einem der vorhergehenden Ansprüche,
wobei
während des Betriebs des lichtemittierenden Bauteils das lichtemittierende Element und das Filterelement unabhängig voneinander ansteuerbar sind.

13. Bauteil (1) nach einem der vorhergehenden Ansprüche,
wobei
während des Betriebs des lichtemittierenden Bauteils (1) das lichtemittierende Element und das Filterelement gemeinsam ansteuerbar sind.

## Revendications

1. Composant électronique électroluminescent (1) comprenant:
- au moins un élément électroluminescent présentant une couche électroluminescente (4) connectée de manière conductrice à et disposée entre une première électrode (3) et une seconde électrode (5) et étant destinée à émettre de la lumière d'une répartition spectrale prédéterminée,
- au moins un élément filtrant présentant une couche filtrante (8) dotée d'un matériau de filtrage électrochrome connecté de manière conductrice à et disposé entre un premier contact (7) et un deuxième contact (9), dans lequel l'élément électroluminescent et l'élément filtrant sont intégrés dans un empilement de couches commun de telle sorte que le premier contact (7), la couche filtrante (8), le deuxième contact (9), la première électrode (3), la couche électroluminescente (4) et la deuxième électrode (5) sont empilés en une structure multicouche sur une fenêtre commune (2),
dans lequel
- l'au moins un élément filtrant est agencé dans le trajet de faisceau de la lumière de répartition spectrale prédéterminée; et
- les propriétés de transmission du matériau filtrant de la couche filtrante (8) sont susceptibles d'être ajustés électriquement pendant l'exploitation du composant électronique électroluminescent (1), de telle sorte que des changements dans les propriétés de transmission du matériau filtrant, en ce qui concerne la lumière de répartition spectrale prédéterminée, provoquent un changement dans la répartition spectrale de la lumière émise par le composant électronique électroluminescent.

2. Composant (1) selon la revendication 1,
dans lequel
la couleur de la lumière émise par le composant (1) est susceptible d'être ajustée en ajustant les propriétés de transmission de l'élément filtrant.

3. Composant (1) selon l'une quelconque des revendications précédentes,
dans lequel
l'élément électroluminescent comprend au moins un élément opto-électronique.

4. Composant (1) selon l'une quelconque des revendications précédentes,
dans lequel
l'élément électroluminescent comprend au moins un élément électroluminescent organique.

5. Composant (1) selon l'une quelconque des revendications précédentes,
dans lequel
l'élément électroluminescent comprend une structure de diode électroluminescente organique.

6. Composant (1) selon l'une quelconque des revendications précédentes, dans lequel
le matériau filtrant comprend des particules présentes dans un fluide, dans lequel les propriétés de transmission des particules sont susceptibles d'être ajustées électriquement.

7. Composant (1) selon la revendication 1,
dans lequel
le matériau électrochrome contient au moins un matériau inorganique.

8. Composant (1) selon la revendication 7,
dans lequel
le matériau inorganique est un oxyde de tungstène.

9. Composant (1) selon la revendication 1,
dans lequel
le matériau électrochrome contient au moins un matériau organique.

10. Composant (1) selon la revendication 1,
dans lequel
en ajustant les propriétés de transmission du matériau filtrant, un maximum local ou global dans la transmission du matériau électrochrome est électriquement décalé vers des longueurs d'ondes supérieures ou inférieures, provoquant une augmentation de l'absorption dans, respectivement, des zones de longueurs d'ondes inférieures ou de longueurs d'ondes supérieures.

11. Composant (1) selon l'une quelconque des revendications précédentes,
dans lequel
l'élément électroluminescent et l'élément filtrant sont agencés dans un boîtier commun.

12. Composant (1) selon l'une quelconque des revendications précédentes,
dans lequel
l'élément électroluminescent et l'élément filtrant peuvent être actionnés indépendamment l'un de l'autre au cours de l'exploitation du composant électroluminescent.

13. Composant (1) selon l'une quelconque des revendications précédentes,
dans lequel
l'élément électroluminescent et l'élément filtrant peuvent être actionnés de manière commune au cours de l'exploitation du composant électroluminescent (1).
